# EUROPEAN PATENT SPECIFICATION

(11) **EP 2 898 548 B1**
(45) Date of publication and mention of the grant of the patent: **20.04.2016**
(21) Application number: 13785633.2
(22) Date of filing: 28.08.2013
(51) Int. Cl.: H01L 33/50, F21K 99/00, F21V 7/04, F21V 7/08, F21Y 113/00, F21V 13/08

(54) **A LIGHT EMITTING ASSEMBLY, A LAMP AND A LUMINAIRE**
LICHTEMITTIERENDE ANORDNUNG, LAMPE UND LEUCHTE
ENSEMBLE ÉLECTROLUMINESCENT, LAMPE ET DISPOSITIF D'ÉCLAIRAGE

(30) Priority: 21.09.2012 US 201261704210 P
(43) Date of publication of application: 29.07.2015
(73) Proprietor: Koninklijke Philips N.V., 5656 AE Eindhoven (NL)
(72) Inventor: HIKMET, Rifat Ata Mustafa, NL-5656 AE Eindhoven (NL); VAN BOMMEL, Ties, NL-5656 AE Eindhoven (NL); VAN HAL, Paulus Albertus, NL-5656 AE Eindhoven (NL)
(74) Representative: Mallens, Erik Petrus Johannes
(86) International application number: PCT/IB2013/058051
(87) International publication number: WO 2014/045137

(56) References cited:
- WO-A1-2009/150580
- WO-A1-2012/065861
- WO-A1-2012/091975
- WO-A1-2012/104155
- US-A1- 2006 203 468

## Description

### FIELD OF THE INVENTION

The invention relates to light emitting assembly which uses one or more light sources and a luminescent material to create a plurality of primary colors which are mixed to obtain a light emission of a particular color, for example, of a color point close to the black body line of a color space.

### BACKGROUND OF THE INVENTION

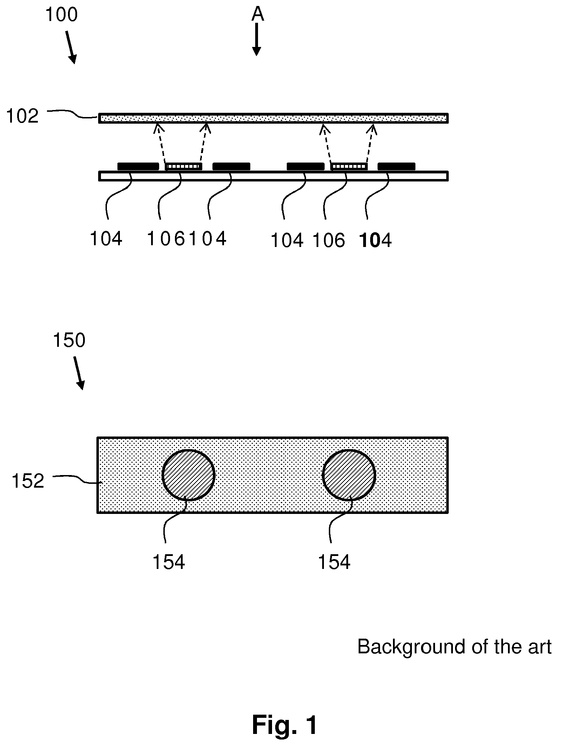

Retrofit light tubes (compatible with luminaires for TL lamps) based on Light Emitting Diodes (LEDs) are becoming an important application. The efficiency of such light tubes is one of the most important differentiators on the market. The use of remote phosphors for creating different primary colors is being considered to obtain efficient LED based retrofit light tubes. A next step in obtaining an increased efficiency is using LEDs which emit a primary color in a relatively narrow light emission band. For example, red, green and blue emitting LEDs are used. However, green emitting LEDs are not efficient enough. As an alternative, it has been suggested to use a blue emitting LED, a red light emitting LED and a luminescent material which emits green light in a relatively narrow light emission band. However, as presented in Fig. 1, the use of red emitting LEDs and a layer with a luminescent material which converts blue light into green light has a specific disadvantage, namely, the disadvantage of visible spots at the light exit window of the particular retrofit light tube.

Fig. 1 presents a cross-sectional view 100 of a light tube in a longitudinal direction of the light tube. At least a portion 102 of the light tube comprises luminescent material which absorbs blue light and converts the absorbed light towards green light. Opposite the luminescent material are arranged Light Emitting Diodes (LEDs) 104, 106 which emit light towards the luminescent material. LEDs 104 emit blue light of which a portion is absorbed by the luminescent material and a portion is emitted through the portion 102 of the light tube without being converted. Thus, the blue LEDs directly and indirectly contribute to the emission of blue and green light by the light tube. LEDs 106 emit red light. The luminescent material in the portion 102 of the light tube is not excited by the red light, and the red light is emitted via the portion 102 into the ambient. Because a relatively large amount of blue light is required and because the blue light is also partially converted, a relatively large amount of blue LEDs 104 are provided and a relatively small amount of red LEDs 106. Thus, the light emitted by the red LEDs 106 only illuminates a subarea of the portion 102 with luminescent material which results in visible bright sport with a reddish color. Because the blue LEDs are in the majority it is not difficult to illuminate the complete portion 102 with the luminescent material with blue light. It may be seen in Fig. 1 that the blue LEDs 104 are arranged close to the red LEDs 106 and that a larger distance is present between neighboring blue LEDs 104 to obtain the illumination of the complete portion 102 with blue light. At the bottom end of Fig. 1 a top view 150 is presented which may be seen when a user looks into the direction *A* (as indicated in the cross-sectional view 100) towards the light tube. Along a large part 152 of the surface of the light tube a combination of blue and green light is emitted. Above the red LEDs 106 a clearly visible spot 154 is observable. The spot 154 has a reddish color and may, depending on the exact mix of different colors, appear white with a little red tint. The spot 154 is at least brighter than the surrounding area and is experienced by the human naked eye as a spot which has a different color than its surroundings. It is not desired to have such visible spots at the surface of the light tube.

WO 2012/104155 discloses luminous devices with several light sources emitting with different colors.

### SUMMARY OF THE INVENTION

It is an object of the invention to provide a light emitting assembly which emits a mix of different colors of light wherein the visibility of spots which are brighter and/or have another color is reduced.

A first aspect of the invention provides a light emitting assembly. A second aspect of the invention provides a lamp. A third aspect of the invention provides a luminaire. Advantageous embodiments are defined in the dependent claims.

A light emitting assembly in accordance with the first aspect of the invention comprises a first light source, a luminescent layer, a reflective area, a second light source and a light exit window for emitting light into the ambient of the light emitting assembly. The first light source emits light in the blue spectral range. The luminescent layer is arranged at the light exit window and at a distance from the first light source and receives light from the first light source. The luminescent layer comprises luminescent material which absorbs a portion of the received light in the blue spectral range and converts a portion of the received light into light in the green spectral range. The reflective area at least partly reflects light towards the luminescent layer. The second light source emits light in the orange, orange/red or red spectral range. The second light source is arranged to emit light in a direction towards the reflective area and not to emit light directly towards the luminescent layer.

The light emitting assembly in accordance with the first aspect of the invention does not emit the orange, the orange/red or red light directly towards the luminescent layer, but the orange, the orange/red or red light is reflected by the reflective area. The reflection at least enlarges the light emission path of the orange, the orange/red or red light and, thus, in specific embodiments, the orange, the orange/red or red light beam may spread towards a wider light beam, and, thus, the orange, the orange/red or red light impinges on a larger area of the luminescent layer. In other specific embodiments the reflective area contributes to an increased area that is being illuminated by red light. Thus, the orange, the orange/red or red light is better spread along the luminescent layer and, if a spot is still visible, the spot will be less bright and will have a larger area. The light output along the luminescent layer has a more homogenous color and a less variation in brightness.

The blue spectral range comprises at least wavelengths in the range from 440 nm to 495 nm. The green spectral range comprises wavelengths in at least the range from 495 to 570nm. The orange spectral range comprises at least wavelengths in the range from 590 to 620nm, the red spectral range comprises at least wavelengths in the range from 620 to 750nm, and the orange/red spectral range comprises wavelengths close to the transition from the orange spectral range to the red spectral range. It is to be noted that the first light source, the luminescent material and the second light source emit light in a specific spectral range. This must be interpreted that a relatively large portion of the emitted light is emitted at wavelengths in these spectral range, but that tails of the wavelength distribution of the light emission may be outside these spectral ranges. However, the amount of energy emitted outside the specific spectral ranges is relatively small, and, thus, if the human eye receives the specific light emission, the human naked eye experiences light in the blue spectral range as blue light, light in the green spectral range as green light, light in the orange, orange/red or red spectral range as orange, orange/red or red light.

Optionally, the second light source emits a diverging light beam and the reflective area is a flat specular reflective area, or the reflective area is configured to increase an area of the luminescent layer which is illuminated by the reflected light in comparison to the area which is illuminated by a flat specular reflective area. Thus, when the second light source is a diverging light beam, and the light is reflected according to the law of 'angle of incidence is angle of reflection', the enlarged light emitted path of the orange, the orange/red or red light results in an enlargement of the width of the red colored light beam which leads to a larger illuminated area of the luminescent layer by the orange, the orange/red or red light. If this is not the case, the reflective area acts as a means which increases the area that is being illuminated by the red light.

Optionally, the reflective area is non-flat. For example, the non-flat reflective area comprises protrusions or recesses of a particular shape (e.g. a U shape, a V shape, ridges and valleys, or bumps, or pyramids, or a wave pattern) and the protrusions and/or recesses emit a portion of the light beam of orange, the orange/red or red light into other directions than other portions of the reflective surface. Consequently, a larger part of the luminescent layer receives orange, the orange/red or red light from a single second light source. In this exemplary embodiment, the reflective area may be specular reflective. The specific arrangement of the second light source in relation to the shape of the reflective surface may also increase the area which is illuminated by the reflected orange, the orange/red or red light.

In an embodiment, the reflective surface is configured to increase the width of the angular light emission distribution. The angular light emission distribution may be expressed as the Full Width Half Maximum width of the angular light emission distribution is made. An angular light emission distribution represents the emitted light intensity at specific light emission angles. The light emission angles are expressed as an angle with respect to a normal to the light emitting surface (of the second light source), or may be expresses as an angle with respect to a central axis of the light beam. It is noted that a flat surface which is specular reflective does not increase the width of the angular light emission distribution because the angle of incidence of each individual light ray results in an equal angle of reflection by the specular reflective surface. However, as soon as not all light rays are exactly reflected into the same direction, the width of the angular light emission distribution increases.

Optionally, the reflective area is diffusely reflective to increase the angular width of the light emission distribution of the light emitted by the second light source. As discussed above, thereby a larger area of the luminescent layer is illuminated by the orange, the orange/red or red light.

Optionally, the reflective area has a cross-sectional shape of a portion of a circle or a portion of an ellipse. Such shapes may act as a diverging reflector. The second light source must be arranged such that the diverging character of such a reflective area is being used. If the reflector initially diverges light towards a focal point, this focal point must be located closer to the reflector than to the luminescent layer such that the light diverges enough after the focal point.

Optionally, an angle between a first central light emission vector of the light beam emitted by the first light source and a second central light emission vector of the light beam emitted by the second light source is in the range from 100 to 260 degrees. Thus, if starting points of the first central light emission vector and the second central light emission vector are aligned, the angle in between the first central light emission vector and the second central light emission vector is larger than 100 degrees and smaller than 260 degrees. It results in a relative orientation of the first light beam emitted by the first light source with respect to the second light beam emitted by the second light source which effectively allows an arrangement of the light source, the luminescent layer and the reflective area such that light of the second light source is not directly emitted towards the luminescent layer, but is emitted via the reflective are to the luminescent layer. Optionally, the angle is in a range from 130 to 230 degrees. In another optional embodiment, the angle is in a range from 160 to 200 degrees.

Optionally, the direction in which the second light source emits its light is in a direction substantially opposite the direction in which the first light source emits light. This optional embodiment better prevents that the light from the second light source is directly emitted towards the luminescent layer, and it thereby prevents that a viewer may see spots which are caused by the illumination of the luminescent layer by light which directly originates from the second light source.

Optionally, the width of the wavelength distribution of the light emission of at least one of the first light source, the second light source and the luminescent material is smaller than 50 nanometer, the width being expressed as a full width half maximum value. The wavelength distribution of the light emission is the distribution of emitted light intensities at specific wavelengths. If the width of the wavelength distribution is relatively small, the light emitting assembly is relatively efficient compared to light emissions with a wider light emission distribution. Optionally, in another embodiment, the width of the wavelength distribution of the light emission of at least one of the first light source, the second light source and the luminescent materials is smaller than 40 nanometer. Optionally, in another embodiment, the width of the wavelength distribution of the light emission of at least one of the first light source, the second light source and the luminescent materials is smaller than 30 nanometer. It is to be noted that the light emission of the luminescent material is the light which is generated by the luminescent material in response to absorbing light of another color. The light emission of the luminescent material does not related to light which is being transmitted through the luminescent layer without being absorbed.

Optionally, the first light source is arranged on the reflective area. This position of the first light source is advantageous because the light reflected by the reflective area and the light emitted by the first light source follow about the same light emission path from the reflective area towards the luminescent layer, which prevents that different colors are visible when a user looks from different angles towards the light emitting assembly.

Optionally, the light emitting assembly further comprises a housing. The housing encloses a cavity. The first light source and the second light source being arranged in the cavity. Light is emitted through the light exit window into the ambient of the light emitting assembly.

The housing is not limited to a particular shape. In an embodiment, the housing may have a cylindrical shape or the shape of a box. In other embodiments, the housing has an elliptical cross sectional shape.

Optionally, the housing comprises an opposite surface. The opposite surface faces the cavity, faces the reflective area and does not face the light exit window. The second light source is arranged on the opposite surface. Thus, the opposite surface is arranged such that the light of the second light source is automatically directed toward the reflected area and not to the light exit window. Therefore, the light of the second light source has a longer light emission path and will illuminate a larger area of the luminescent area, thereby reducing the brightness of spots and/or visible color differences of spots.

Optionally, the housing comprises a protruding element which protrudes into the cavity. A surface of the protruding element is the opposite surface. Thus, a protruding element, which may be a flange like protrusion or which may be a panel like protrusion, is provided which has at least one surface which does not face towards the luminescent layer and which faces towards the reflective area. Such a protruding element is an effective solution for arranging the second light source at an advantageous position such that the brightness of spots and/or visible color differences are reduced.

Optionally, the housing comprises at least one flat wall and the flat wall comprises the light exit window. Further, the flat wall comprises at least at an edge of the light exit window an opaque wall-portion which comprises the opposite surface. Thus, at least at one side of the light exit window the housing has a flat wall portion of which a surface which faces the cavity is the opposite surface. In such an embodiment, the second light source and/or the opposite surface do not create any shadow on the light exit window which increases the color and intensity uniformity of the light output along the light exit window. In another embodiment, the housing has only one flat wall which comprises the light exit window and the flat wall portion with the second light source. In an embodiment, the housing may have a box-shape and, thus, has 6 flat walls All walls of the box may be opaque, except the portion which forms the light exit window.

Optionally, the reflective area is at least a portion of a surface of the housing which faces the cavity. If one or more surfaces of the housing which face the cavity are reflective, one doesn't have to introduce additional components for creating the reflective area. Further, light rays which travel through the cavity and which do not directly fall on the light exit window are reflected and recycled and, thus, a light emitting assembly with a high efficiency can be obtained when some or all walls are reflective. In this embodiment, not only the light of the second light source is reflected towards the luminescent layer, also light that is, for example, back reflected by the luminescent layer, or that is emitted by the luminescent layer into the cavity, is not absorbed but recycled.

Optionally, the luminescent layer is arranged at the light exit window.

In accordance with a second aspect of the invention, a lamp is provided which comprises the light emitting assembly according to the first aspect of the invention. A lamp may be, for example, a retrofit light-bulb or a retrofit light-tube. In another embodiment, the lamp may be a LED module which is a small box (rectangular or cylindrical) wherein Light Emitting Diodes form the first light source and the second light source and one of the surfaces of the box is a light exit window.

In accordance with a third aspect of the invention, a luminaire is provided which comprises the light emitting assembly according to the first aspect of the invention or which comprises the lamp according to the second aspect of the invention.

The lamp according to the second aspect of the invention and the luminaire according to the third aspect of the invention provide the same benefits as the light emitting assembly according to the first aspect of the invention and have similar embodiments with similar effects as the corresponding embodiments of the system.

These and other aspects of the invention are apparent from and will be elucidated with reference to the embodiments described hereinafter.

It will be appreciated by those skilled in the art that two or more of the above-mentioned options, implementations, and/or aspects of the invention may be combined in any way deemed useful.

Modifications and variations of the assembly, the lamp and/or the luminaire, which correspond to the described modifications and variations of the light emitting assembly, can be carried out by a person skilled in the art on the basis of the present description.

### BRIEF DESCRIPTION OF THE DRAWINGS

In the drawings:
Fig. 1 schematically shows an embodiment of a light tube which is discussed in the background of the art section,
Fig. 2 schematically shows an embodiment of a light emitting assembly according to the first aspect of the invention,
Fig. 3a schematically shows an embodiment of a retro-fit light tube comprising a light emitting assembly according to the first aspect of the invention,
Fig. 3b schematically shows another embodiment of a retro-fit light tube comprising a light emitting assembly,
Fig. 4 schematically shows a LED module comprising a light emitting assembly according to the first aspect of the invention,
Fig. 5 schematically shows a retro-fit light bulb comprising a light emitting assembly,
Fig. 6 schematically shows a luminaire according to the third aspect of the invention.

It should be noted that items denoted by the same reference numerals in different Figures have the same structural features and the same functions, or are the same signals. Where the function and/or structure of such an item have been explained, there is no necessity for repeated explanation thereof in the detailed description.

The Figures are purely diagrammatic and not drawn to scale. Particularly for clarity, some dimensions are exaggerated strongly.

### DETAILED DESCRIPTION

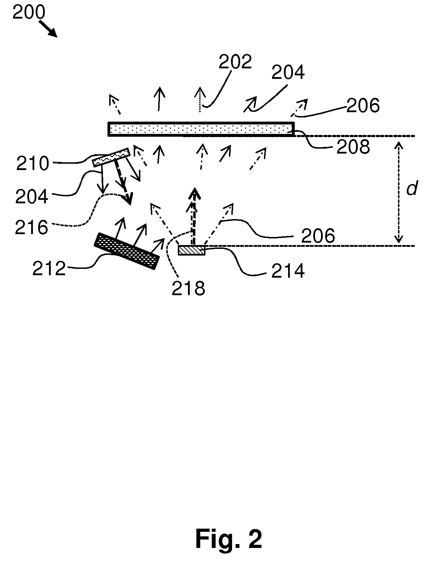

Fig. 2 schematically shows an embodiment of a light emitting assembly 200 according to the first aspect of the invention. Fig. 2 presents a cross-sectional view. The presented elements of the light emitting assembly 200 may extend for some distance in a direction perpendicular to the plane of the figure.

The light emitting assembly 200 comprises a first light source 214, a second light source 210, a luminescent layer 208 and a reflective area 212. The first light source 214 emits light 206 in the blue spectral range if the first light source 214 is in operation. The blue spectral range comprises wavelengths in the range from 440 nm to 495 nm. Thus, the light emitted by the first light source 214 is perceived by the human naked eye as light 206 of a blue color. The blue light 206 is emitted towards the luminescent layer 208.

The luminescent layer 208 is arranged at a distance d away from the first light source 214. The distance d may be 1 millimeter, and may also be a larger value, for example, 1 or 2 centimeter. Especially when the luminescent layer 208 is arranged more than 2 millimeter away from the first light source 214, the luminescent layer 208 is arranged in a so-termed remote configuration. The luminescent layer 208 comprises luminescent material which is configured to absorb a portion of the received blue light 206 and which is configured to convert a portion of the received light into light 202 in the green spectral range. The green spectral range comprises wavelengths in the range of 495 nm to 570 nm. Thus, based on the light 206 emitted by the first light source, light transmitted through the luminescent layer 208 and emitted by the luminescent layer 208 comprises at least blue light 206 and green light 202.

The second light source 210 emits, in operation, light 204 in the orange, orange/red or red spectral range. The orange spectral range comprises wavelengths in the range from 590 to 620nm, the red spectral range comprises wavelengths in the range from 620 to 750n, and the orange/red spectral range comprises wavelengths close to the transition from the orange spectral range to the red spectral range. Thus, the second light source 210 emits light 204 which is perceived by the human naked eye as orange, orange/red or red light 204. In the following of this document the term red light 204 is used to refer to the orange, orange/red or red light 204 emitted by the second light source 204, thus, when the term red light is used, orange light and orange/red light may be read instead of red light. The second light source 210 is arranged in a relative position with respect to the reflective area 212 and the luminescent layer 208 such that light 204 emitted by the second light source 210 is not directly emitted towards the luminescent layer 208 and such that light 204 emitted by the second light source 210 is emitted towards the reflective area 212.

The reflective area 212 is specular or diffusely reflective and reflects at least a part of the received light towards the luminescent layer 208. In the light emitting assembly 200, the reflective area 212 receives red light 204 emitted by the second light source 210, and, consequently, at least a part of the red light 204 is reflected towards the luminescent layer 208. As seen in Fig. 2, the light beam emitted by the second light source 210 is a diverging light beam and because of the reflection via the reflective area 212, the red light 204 has to travel along a relatively large distance and the width of the diverging light beam increased to a relatively wide light beam when the light arrives at the luminescent layer 208. Thus, red light 204 impinge on a relatively large area of the luminescent layer 208. The luminescent layer 208 does not comprise a material which converts the red light 204 to another color of light, and, consequently, red light 204 is transmitted through the luminescent layer 208. Finally, the light, which is emitted by and transmitted through the luminescent layer 208, comprises green light 202, red light 204 and blue light 206. The different colors of light are emitted along a relatively large area of the luminescent layer 208, and every color of light is emitted in a relatively homogenous distribution along the relatively large area of the luminescent layer 208. No bright spots, or spots of a different color, may be seen at the luminescent layer 208.

In Fig. 2 a first central light emission vector 218 of the light beam emitted by the first light source 210 and a second central light emission vector 216 of the light beam emitted by second light source are drawn. The central light emission vector represents the average of all directions in which the light of the light beam is emitted. An angle between the first central light emission vector 218 and the second central light emission vector 216 is in a range from 100 to 260 degrees. Optionally, the angle is in a range from 130 to 230 degrees. In the embodiment of Fig. 2, the angle is in a range from 160 to 200 degrees. It is to be noted that the angle must be measured by aligning the starting points of the vectors to a common point and measuring the angle between the first central light emission vector 218 and the second central light emission vector 216.

In a summary, the light emitting assembly 200 comprises a first light source 214, a luminescent layer 208, a reflective area 212 and a second light source 210. The first light source 210 emits blue light 206 towards the luminescent layer 208 which is arranged at a distance from the first light source 214. The luminescent layer 208 comprises luminescent material which absorbs a portion of the received blue light 206 and converts a portion of the received light into green light 202. The second light source 210 emits orange, orange/red or red light towards the reflective area which reflect it towards the luminescent layer 208. The second light source 210 does not emit light 204 directly towards the luminescent layer 208.

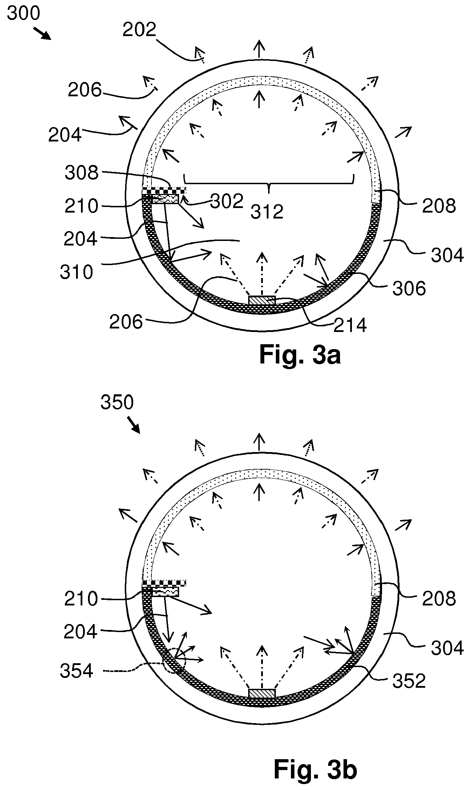

Fig. 3a schematically shows an embodiment of a retro-fit light tube 300 comprising a light emitting assembly according to the first aspect of the invention. Fig. 3a shows a cross-sectional view, which means that all presented elements of the cross-sectional view may extend for some distance in a direction perpendicular to the plane of the drawing. Further, some of the elements may repeat in the perpendicular direction. For example, more light sources 210, 214 may be presents in the light tube 300 at positions on a line perpendicular to the plane of the figure.

The retro-fit light tube 300 comprises a hollow glass tube 304 which encloses a cylindrical shaped cavity 310. Within the cavity 310 at a portion of the glass tube 304 is provided a reflective layer 306, which is, in the example of Fig. 3a, a specular reflective layer. At one end of the reflective layer 306, a flange-like element 308 protrudes into the cavity 310. The flange-like element 308 may also be described as an elongated panel-like element which is arranged with one of its (longest) edges to the edge of the reflective layer 306 and extends into the cavity into a direction of a central axis of the glass tube 304. The portion of the glass tube 304 which is not covered by the reflective layer 306, is the light exit window 312. At the light exit window 312 is provided a luminescent layer 208. The reflective layer 306 is configured to reflect light which impinges on the reflective layer 306 towards the light exit window 312 and, thus, to the luminescent layer 208. The retro-fit light tube 300 further comprises first light sources 214 and second light sources 210. The in the lateral direction of the retro-fit light tube 300 a plurality of first light sources 214 are provided on the reflective layer 306. The first light sources 214 emit blue light 214 towards the luminescent layer 208. The flange-like element 308 has an opposite surface 302 which faces the reflective area 306 but does not directly face the light exit window 312. The second light sources 210 are provided on the opposite surface 302 of the flange-like element 308 and emit, in operation, red light 306 towards the reflective area 306. The cross-sectional shape of the reflective area 306 is, in this specific embodiment, circular shaped and, thus, the light which is impinges on it is first reflected to a focal point and spreads after the focal point into a wide light beam. The specific configuration of the reflective area 306 results in a reflection of red light 204 such that it impinges on, about, the whole luminescent layer 208. As discussed in the context of Fig. 2, the red light 204 is transmitted through the luminescent layer 208. Also in line with the previous discussion of the luminescent layer 208, a portion of the blue light 204 is transmitted through the luminescent layer 208, and a portion of the blue light is converted by the luminescent material of the luminescent layer 208 towards green light 202. Thus, the retro-fit light tube 300 emits along its light exit window 312 a relatively homogenous light emission which does not comprises much bright spots or spots of another color of light. It is to be noted that the reflective layer 306 has another advantage which results from the fact that the luminescent layer 208 may also emit some green light 202 backwards towards the reflective layer 306 and that light which impinges on the luminescent layer 208 may be partially back-reflected towards the reflective layer 306. The reflective layer reflects this back-reflected or backwards emitted light once again towards the luminescent layer 208 such that this light gets another possibility to be transmitted into the ambient. Thus, the reflective layer 306 assists in the recycling of back-reflected and backwards emitted light and, consequently, the reflective layer 306 contributes to the efficiency of the retro-fit light tube 300.

Fig. 3b schematically shows another embodiment of a retro-fit light tube 350. The retro-fit light tube 350 is similar to retro-fit light tube 300 of Fig. 3a, however, a difference is that retro-fit light tube 350 comprises a diffusely reflective layer 352 instead of the specularly reflective layer 306. Thus, red light 204 which is emitted by the second light sources 210 impinges on the diffusely reflective layer 352 and is emitted in a plurality of directions. This is illustrated at location 354: one light ray of red light 204 impinges on the diffusely reflective layer 352 and the red light 204 is reflected in a plurality of directions. Thereby the angular width of the light beam emitted by the second light source 210 is increased. The angular width of the light beam may be measured with respect to a central axis of the light beam and is the maximum angle between this central axis and the most outside light ray of the light beam. The diffusely reflective layer 352 at least increases the angular width of the light beam of red light 204 with 20 degrees, or, in another embodiment, with 40 degrees. The diffusely reflective layer 352 contributes to a better spreading of the red light 204 such that the red light arrives at the luminescent layer in a more homogeneous light distribution which, consequently, results in a more homogeneous light output through the light exit window of the retro-fit light tube 350. As discussed above, the diffusely reflective layer 352 also contributes to the recycling of light and, consequently, contributes to the efficiency of the retro-fit light tube 350.

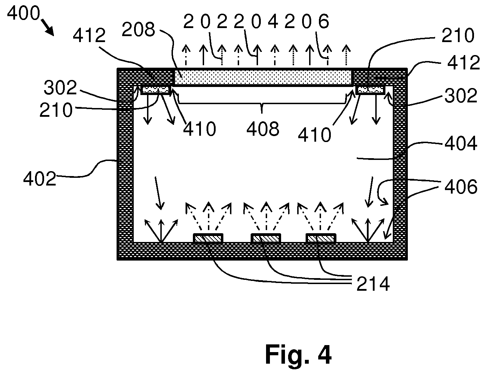

Fig. 4 schematically shows a LED module 400 comprising a light emitting assembly according to the first aspect of the invention. The LED module 400 comprises a housing 402 of opaque diffusely reflective walls which enclose a cavity 404. The inner surfaces 406 of the walls, which are the surfaces 406 of the walls which face the cavity 404, are diffusely reflective and, thus, diffusely reflect light which impinges on them. One of the walls comprises a light exit window 408 which is at least partially light transmitting. The wall with the light exit window 408 still comprises, at the edge 410 of the light exit window 408, an opaque portion 412 of the wall. A surface of the opaque portion 412 of the wall which faces the cavity is termed the opposite surface 302. The opposite surface 302 faces at least one of the diffusely reflective inner surfaces 406 of the walls of the housing 402 and does not face the light exit window 408. Second light sources 210 are arranged on the opposite surfaces 302 and the second light sources 210 emit red light 204 into the cavity and they do not emit red light 204 directly towards the light exit window 408. The red light 204 is diffusely reflected by the inner surfaces 406 of the walls and arrives in a substantially homogenous light emission distribution at the light exit window 408. A plurality of first light source 214 are provided at one of the diffusely reflective surfaces 406 which is opposite the light exit window 408. All first light sources 214 emit blue light 206 at least towards the light exit window 408 and, as such, a relatively homogenous light emission of blue light 206 arrives at the light exit window. The light exit window 408 is formed by a luminescent layer 208 which comprises luminescent material. The luminescent material absorbs a portion of the blue light 206 and converts a portion of the absorbed light towards green light 202. A non-absorbed portion of the blue light is transmitted through the luminescent layer 208 into the ambient of the LED module 400. A substantially large part of the generated green light 202 is emitted into the ambient. The red light 202, which impinges on the luminescent layer, is transmitted for a large part through the luminescent layer 208. Thus, the light emission of the LED module comprises a substantially homogenous light output which comprises blue light 206, green light 202 and red light 204.

It is to be noted that in Fig. 4 the cavity does not comprise any specific (solid) material and is at least light transmitting. Thus, the cavity may be filled with environmental air or any specific light transmitting gas. In another embodiment, the cavity is filled with a light transmitting resin which transmits red light 204 and blue light 206 from the light source 210, 214 to the diffusely reflective surfaces 406 of the walls and/or to the light exit window 408. In such an embodiment, the light transmitting resin must be optically coupled to a light emitting surface of the light source 210, 214, must be optically coupled to a relatively large portion of the diffusely reflective surfaces 406, and must be optically coupled to the luminescent layer 208, such that the light 204, 206 can be transmitted into the luminescent layer 208. The light transmitting resin may assist in the outcoupling of light from the light source 210, 214.

The embodiment of Fig. 4 shows a LED module 400, which means that the light sources are solid state light emitters. A Light Emitting Diode (LED) is an example of a solid state light emitter. Further, Fig. 4 shows a cross-sectional view of the LED module 400, which means that the LED module 400 extends further into a direction perpendicular to the plane of the drawing. The presented cross-sectional view may be a cross-section of a cylindrical-shaped LED module 400 which has two flat walls and a wall which has an annular cross-sectional shape, wherein one of the flat walls comprising the light exit window 408. Alternatively, the LED module 400 may be a box-shaped LED module 400 which comprises six flat walls which of which one of the flat walls comprises the light exit window 408.

Fig. 4 does not show any particular size of the LED module 400. It is to be noted that the LED module 400 may have a dimension in the millimeter range, which means that its width, height and depth are not larger than 1 centimeter. Such a relatively small LED module allows an integrated of the LED module 400 in, for example, retro-fit light bulbs. The size of the LED module 400 may be larger, such that, for example, the dimensions width, height or depth are larger than 5 centimeter. Such LED modules 400 may be integrated in specific luminaires which are designed to comprise a LED module of a particular size. The dimensions width, height and depth may also have a value which is in between the above discussed ranges.

The embodiments discussed in this document are not limited to any particular type of light source. It is only important that light source are used which emit light in the blue spectral range and that light sources are used which emit light in the orange, orange/red or red spectral range. In an embodiment the light sources are solid state light emitters. Examples of solid state light emitters are Light Emitting Diodes (LEDs), Organic Light Emitting diode(s) OLEDs, or, for example, laser diodes. For example, GaN or InGaN based LEDs may emit blue light with wavelengths in the range from 440 to 460 nm. In an alternative embodiment, traditional incandescent lamps are used in combination with a color filter.

In an optional embodiment, the light sources and/or the luminescent material of the previously discussed embodiments emit light in a relatively narrow wavelength distribution, which means that most of the light energy is emitted in a relatively narrow portion of the visible spectral range. For example, the width of the wavelength distribution of the light emission of the light sources and/or luminescent material is smaller than 50nm measured at Full Width Half Maximum (FWHM). In other embodiments the width of the wavelength distribution of the light emission of the light sources and/or luminescent material is smaller than 40nm FWHM. In yet another embodiment, the width of the wavelength distribution of the light emission of the light sources and/or luminescent material is smaller than 30nm FWHM.

The luminescent material may be selected from group of organic phosphors, inorganic phosphors, or luminescent material comprising particles showing quantum confinement and have at least in one dimension a size in the nanometer range.

If the luminescent material comprises particles which show quantum confinement it means that the particles have optical properties that depend on the size of the particles. Examples of such materials are quantum dots, quantum rods and quantum tetrapods. A size in the nanometer range in at least in one dimension means, for example, that, if the particles are substantially spherical, their diameter is in the nanometer range. Or, this means, for example, if they are wire-shaped, that a size of a cross-section of the wire is in one direction in the nanometer range. A size in the nanometer range means that their size is at least smaller than 1 micrometer, thus, smaller than 500 nanometer, and larger or equal to 0.5 nanometer. In an embodiment, the size in one dimension is smaller than 50 nanometer. In another embodiment the size in one dimension is in the range from 2 to 30 nanometer.

In embodiments of the invention the wavelength converting material may comprise quantum dots (QDs). Quantum dots are small crystals of semiconducting material generally having a width or diameter of only a few nanometers. When excited by incident light, a quantum dot emits light of a color determined by the size and material of the crystal. Light of a particular color can therefore be produced by adapting the size of the dots. This means that by using quantum dots any spectrum can be obtained as they are narrow band emitters.

Most known quantum dots with emission in the visible range are based on cadmium selenide (CdSe) with shell such as cadmium sulfide (CdS) and zinc sulfide (ZnS). Cadmium free quantum dots such as indium phosphode (InP), and copper indium sulfide (CuInS₂) and/or silver indium sulfide (AgInS₂) can also be used. Quantum dots show very narrow emission band and, thus, they show saturated colors. Furthermore, the emission color can easily be tuned by adapting the size of the quantum dots. Any type of quantum dot known in the art may be used in the present invention, provided that it has the appropriate wavelength conversion characteristics. However, it may be preferred for reasons of environmental safety and concern to use cadmium-free quantum dots or at least quantum dots having very low cadmium content.

Organic phosphors, which emit in a relatively narrow light emission band, are highly suitable for use in the embodiments of the invention. Organic phosphors suffer from a relatively low photo-chemical stability. Their stability strongly depends on the temperature of the material and on the amount of light that it converts. For this reason, organic phosphor is a suitable candidate for use in the remote configuration, which means that a gap is present between the light sources and the luminescent layer comprising the luminescent material. A lighting assembly using organic remote phosphor is relatively cheap because of the use of relatively cheap organic luminescent material. Furthermore, organic luminescent materials allow an easy design of a specific organic luminescent material which has a light emission spectrum anywhere in the green part of the visible light range. Such molecules can be synthesized and depending on the molecular structure they will emit at specific wavelengths.

Inorganic phosphors are typical broad band emitter. However, a few phosphor types are narrow band emitters. We suggest using these "green" emitting phosphors with a narrow emission characteristics, such as, for example, SrGa₂S₄:Eu²⁺.

The luminescent layer may be manufactured by depositing a layer with luminescent material on flat a light transmitting substrate. In another embodiment, the quantum dots or the organic phosphors are dispersed in a matrix polymer, or the organic phosphors are diluted in a matrix polymer, and a layer of the matrix polymer with luminescent material is manufactured. Examples of suitable matrix polymers are Polymethyl methacrylate (PMMA), Polyethylene terephthalate (PET), Polyethylene naphthalate (PEN) or polycarbonate (PC). In other embodiments, an inorganic phosphor forms the basis of a ceramic luminescent layer.

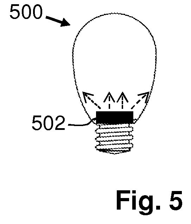

Fig. 5 schematically shows a retro-fit light bulb 500 comprising a light emitting assembly. The retrofit light bulb 400 comprises a base on which a light emitting assembly 502 in accordance with the first aspect of the invention is provided. The light emitting assembly 502 may also be a LED box which is similar to LED box 400 of Fig. 4.

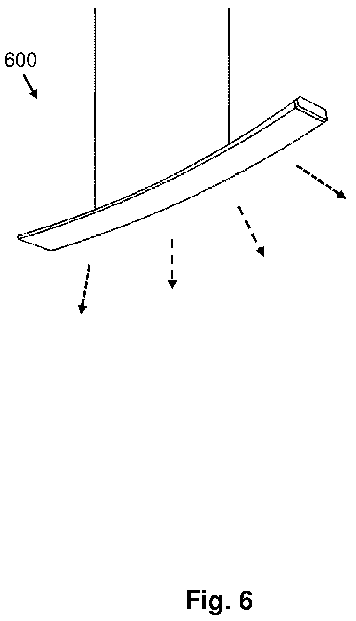

Fig. 6 schematically shows a luminaire 600 according to the third aspect of the invention. The luminaire 600 comprises one or more light emitting assemblies according to the first aspect of the invention or comprises a lamp according to the second aspect of the inventions. The lamp may be, for example, the retro-fit light tube 300, 350 of, respectively, Fig. 3a or Fig. 3b, or the lamp is, for example, the retro-fit light bulb 500 of Fig. 5.

It should be noted that the above-mentioned embodiments illustrate rather than limit the invention, and that those skilled in the art will be able to design many alternative embodiments without departing from the scope of the appended claims.

In the claims, any reference signs placed between parentheses shall not be construed as limiting the claim. Use of the verb "comprise" and its conjugations does not exclude the presence of elements or steps other than those stated in a claim. The article "a" or "an" preceding an element does not exclude the presence of a plurality of such elements. The invention may be implemented by means of hardware comprising several distinct elements. In the device claim enumerating several means, several of these means may be embodied by one and the same item of hardware. The mere fact that certain measures are recited in mutually different dependent claims does not indicate that a combination of these measures cannot be used to advantage.

## Claims

1. A light emitting assembly (200, 502) comprising:
- a light exit window (312, 408) for emitting light into the ambient of the light emitting assembly,
- a first light source (214) being configured to emit light (206) in the blue spectral range,
- a luminescent layer (208) arranged at the light exit window and being arranged at a distance from the first light source (214) and being configured to receive light (206) from the first light source (214), the luminescent layer (208) comprises luminescent material being configured to absorb a portion of the received light (206) in the blue spectral range and to convert a portion of the received light into light (202) in the green spectral range,
- a reflective area (212, 306, 352, 406) for at least partly reflecting light towards the luminescent layer (208),
- a second light source (210) being configured to emit light (204) in the orange, orange/red or red spectral range, the second light source (210) being arranged to emit light (204) in a direction towards the reflective area (212, 306, 352, 406) and not to emit light (204) directly towards the luminescent layer (208).

2. A light emitting assembly (200, 502) according to claim 1, wherein the second light source (210) emits a diverging light beam and the reflective area (212, 306, 352, 406) is a flat specular reflective area, or the reflective area (212, 306, 352, 406) is configured to increase an area of the luminescent layer (208) which is illuminated by the reflected light in comparison to an area which is illuminated by a flat specular reflective area.

3. A light emitting assembly (200, 502) according to claim 1 or 2, wherein the reflective area (212, 306, 352, 406) has a cross-sectional shape of a portion of a circle or a portion of an ellipse.

4. A light emitting assembly (200, 502) according to claim 1 or 2, wherein the reflective area (212, 306, 352, 406) is diffusely reflective for increasing the angular width of the light emission distribution of the light (204) emitted by the second light source (210).

5. A light emitting assembly (200, 502) according to claim 1, wherein an angle between a first central light emission vector (218) of a light beam emitted by the first light source (214) and a second central light emission vector (216) of a light beam emitted by the second light source (210) is in the range from 100 to 260 degrees.

6. A light emitting assembly (200, 502) according to claim 1, wherein the width of the wavelength distribution of the light emission of at least one of the first light source (214), the second light source (210) and the luminescent material is smaller than 50 nanometer, the width being expressed as a full width half maximum value.

7. A light emitting assembly (200, 502) according to claim 1, wherein the first light source (214) is arranged on the reflective area (212, 306, 352, 406).

8. A light emitting assembly (200, 502) according to claim 1 further comprising
- a housing (304, 402) for enclosing a cavity (310, 404), the first light source (214) and the second light source (210) being arranged in the cavity (310, 404).

9. A light emitting assembly (200, 502) according to claim 8, wherein the housing (304, 402) comprises an opposite surface (302) facing the cavity (310, 404), facing the reflective area (212, 306, 352, 406) and not facing the light exit window (312, 408), and wherein the second light source (210) is arranged on the opposite surface (302).

10. A light emitting assembly (200, 502) according to claim 9, wherein
- the housing (304, 402) comprises a protruding element (308) protruding into the cavity (310, 404), wherein a surface of the protruding element (308) is the opposite surface (302).

11. A light emitting assembly (200, 502) according to claim 9, wherein
- the housing (304, 402) comprises at least one flat wall,
- the flat wall comprises the light exit window (312, 408) and the flat wall comprises at least at an edge of the light exit window (312, 408) an opaque wall-portion (412) which comprises the opposite surface (302).

12. A light emitting assembly (200, 502) according to claim 8, wherein the reflective area (212, 306, 352, 406) is at least a portion of a surface of the housing (304, 402) which faces the cavity (310, 404).

13. A lamp (300, 350, 400, 500) comprising the light emitting assembly (200, 502) according to any one of the claims 1 to 12.

14. A luminaire (600) comprising the light emitting assembly according to any one of the claims 1 to 12 or comprising the lamp (300, 350, 400, 500) according to claim 13.

## Patentansprüche

1. Licht emittierende Anordnung (200, 502), umfassend:
- ein Lichtaustrittsfenster (312, 408), um Licht in die Umgebung der Licht emittierenden Anordnung zu emittieren,
- eine erste Lichtquelle (214), die so eingerichtet ist, dass sie Licht (206) in dem blauen Spektralbereich emittiert,
- eine lumineszierende Schicht (208), die an dem Lichtaustrittsfenster und in einem Abstand von der ersten Lichtquelle (214) angeordnet und so eingerichtet, dass sie Licht (206) von der ersten Lichtquelle (214) empfängt, wobei die lumineszierende Schicht (208) lumineszierendes Material enthält, das so vorgesehen ist, dass es einen Teil des empfangenen Lichts (206) in dem blauen Spektralbereich absorbiert und einen Teil des empfangenen Lichts in Licht (202) in dem grünen Spektralbereich umwandelt,
- einen reflektiven Bereich (212, 306, 352, 406), um Licht zumindest teilweise zu der lumineszierenden Schicht (208) hin zu reflektieren,
- eine zweite Lichtquelle (210), die so eingerichtet ist, dass sie Licht (204) in dem orangen, orange-roten oder roten Spektralbereich emittiert, wobei die zweite Lichtquelle (210) so angeordnet ist, dass sie Licht (204) in einer Richtung zu dem reflektiven Bereich (212, 306, 352, 406) hin emittiert, nicht jedoch Licht (204) unmittelbar zu der lumineszierenden Schicht (208) hin emittiert.

2. Licht emittierende Anordnung (200, 502) nach Anspruch 1, wobei die zweite Lichtquelle (210) einen divergierenden Lichtstrahl emittiert und der reflektive Bereich (212, 306, 352, 406) ein flacher, spiegelnd reflektiver Bereich ist, oder der reflektive Bereich (212, 306, 352, 406) so vorgesehen ist, dass er einen Bereich der lumineszierenden Schicht (208) vergrößert, der durch einen flachen, spiegelnd reflektiven Bereich beleuchtet wird.

3. Licht emittierende Anordnung (200, 502) nach Anspruch 1 oder 2, wobei der reflektive Bereich (212, 306, 352, 406) eine Querschnittsform eines Teils eines Kreises oder eines Teils einer Ellipse aufweist.

4. Licht emittierende Anordnung (200, 502) nach Anspruch 1 oder 2, wobei der reflektive Bereich (212, 306, 352, 406) diffus reflektiv ist, um die Winkelbreite der Lichtemissionsverteilung des von der zweiten Lichtquelle (210) emittierten Lichts (204) zu erhöhen.

5. Licht emittierende Anordnung (200, 502) nach Anspruch 1, wobei ein Winkel zwischen einem ersten zentralen Lichtemissionsvektor (218) eines von der ersten Lichtquelle (214) emittierten Lichtstrahls und einem zweiten zentralen Lichtemissionsvektor (216) eines von der zweiten Lichtquelle (210) emittierten Lichtstrahls in dem Bereich von 100 bis 260 Grad liegt.

6. Licht emittierende Anordnung (200, 502) nach Anspruch 1, wobei die Breite der Wellenlängenverteilung der Lichtemission von zumindest der ersten Lichtquelle (214), der zweiten Lichtquelle (210) oder dem lumineszierenden Material geringer als 50 Nanometer ist, wobei die Breite als ein Halbwertsbreitenwert ausgedrückt wird.

7. Licht emittierende Anordnung (200, 502) nach Anspruch 1, wobei die erste Lichtquelle (214) auf dem reflektiven Bereich (212, 306, 352, 406) angeordnet ist.

8. Licht emittierende Anordnung (200, 502) nach Anspruch 1, die weiterhin umfasst:
- ein Gehäuse (304, 402) zum Umschließen eines Hohlraumes (310, 404), wobei die erste Lichtquelle (214) und die zweite Lichtquelle (210) in dem Hohlraum (310, 404) angeordnet sind.

9. Licht emittierende Anordnung (200, 502) nach Anspruch 8, wobei das Gehäuse (304, 402) eine gegenüberliegende Oberfläche (302) umfasst, die dem Hohlraum (310, 404) zugewandt ist, dem reflektiven Bereich (212, 306, 352, 406) zugewandt ist, nicht jedoch dem Lichtaustrittsfenster (312, 408) zugewandt ist, und wobei die zweite Lichtquelle (210) auf der gegenüberliegenden Oberfläche (302) angeordnet ist.

10. Licht emittierende Anordnung (200, 502) nach Anspruch 9, wobei
- das Gehäuse (304, 402) ein vorragendes Element (308) umfasst, das in den Hohlraum (310, 404) vorragt, wobei eine Oberfläche des vorragenden Elements (308) die gegenüberliegende Oberfläche (302) ist.

11. Licht emittierende Anordnung (200, 502) nach Anspruch 9, wobei
- das Gehäuse (304, 402) mindestens eine ebene Wand umfasst,
- die ebene Wand das Lichtaustrittsfenster (312, 408) umfasst und die ebene Wand zumindest an einem Rand des Lichtaustrittsfensters (312, 408) einen opaken Wandabschnitt (412) umfasst, der die gegenüberliegende Oberfläche (302) umfasst.

12. Licht emittierende Anordnung (200, 502) nach Anspruch 8, wobei der reflektive Bereich (212, 306, 352, 406) zumindest ein Teil einer Oberfläche des Gehäuses (304, 402) ist, der dem Hohlraum (310, 404) zugewandt ist.

13. Lampe (300, 350, 400, 500) mit der Licht emittierenden Anordnung (200, 502) nach einem der Ansprüche 1 bis 12.

14. Leuchte (600) mit der Licht emittierenden Anordnung nach einem der Ansprüche 1 bis 12 oder mit der Lampe (300, 350, 400, 500) nach Anspruch 13.

## Revendications

1. Ensemble électroluminescent (200, 502) comprenant :
- une fenêtre de sortie de lumière (312, 408) pour émettre de la lumière dans l'environnement ambiant de l'ensemble électroluminescent,
- une première source de lumière (214) configurée pour émettre de la lumière (206) dans le domaine spectral bleu,
- une couche luminescente (208) agencée au niveau de la fenêtre de sortie de lumière et agencée à une certaine distance de la première source de lumière (214) et configurée pour recevoir de la lumière (206) en provenance de la première source de lumière (214), la couche luminescente (208) comprenant un matériau luminescent configuré pour absorber une partie de la lumière reçue (206) dans le domaine spectral bleu et pour convertir une partie de la lumière reçue en lumière (202) dans le domaine spectral vert,
- une zone réfléchissante (212, 306, 352, 406) pour réfléchir au moins partiellement de la lumière vers la couche luminescente (208),
- une seconde source de lumière (210) configurée pour émettre de la lumière (204) dans le domaine spectral orange, orange/rouge ou rouge, la seconde source de lumière (210) étant agencée pour émettre de la lumière (204) dans une direction vers la zone réfléchissante (212, 306, 352, 406) et pour ne pas émettre de la lumière (204) directement vers la couche luminescente (208).

2. Ensemble électroluminescent (200, 502) selon la revendication 1, dans lequel la seconde source de lumière (210) émet un faisceau de lumière divergente et la zone réfléchissante (212, 306, 352, 406) est une zone réfléchissante spéculaire plate, ou la zone réfléchissante (212, 306, 352, 406) est configurée pour augmenter une zone de la couche luminescente (208) qui est illuminée par la lumière réfléchie en comparaison à une zone qui est illuminée par une zone réfléchissante spéculaire plate.

3. Ensemble électroluminescent (200, 502) selon la revendication 1 ou 2, dans lequel la zone réfléchissante (212, 306, 352, 406) a une forme en coupe d'une partie d'un cercle ou d'une partie d'une ellipse.

4. Ensemble électroluminescent (200, 502) selon la revendication 1 ou 2, dans lequel la zone réfléchissante (212, 306, 352, 406) est réfléchissante de façon diffuse pour augmenter la largeur angulaire de la répartition d'émission de lumière de la lumière (204) émise par la seconde source de lumière (210).

5. Ensemble électroluminescent (200, 502) selon la revendication 1, dans lequel un angle entre un premier vecteur central d'émission de lumière (218) d'un faisceau de lumière émis par la première source de lumière (214) et un second vecteur central d'émission de lumière (216) d'un faisceau de lumière émis par la seconde source de lumière (210) se trouve dans la plage de 100 à 260 degrés.

6. Ensemble électroluminescent (200, 502) selon la revendication 1, dans lequel la largeur de la répartition de longueur d'onde de l'émission de lumière d'au moins l'un de la première source de lumière (214), de la seconde source de lumière (210) et du matériau luminescent est inférieure à 50 nanomètres, la largeur étant exprimée en tant que valeur maximale de la demi-largeur totale.

7. Ensemble électroluminescent (200, 502) selon la revendication 1, dans lequel la première source de lumière (214) est agencée sur la zone réfléchissante (212, 306, 352, 406).

8. Ensemble électroluminescent (200, 502) selon la revendication 1, comprenant en outre
- un boîtier (304, 402) pour renfermer une cavité (310, 404), la première source de lumière (214) et la seconde source de lumière (210) étant agencées dans la cavité (310, 404).

9. Ensemble électroluminescent (200, 502) selon la revendication 8, dans lequel le boîtier (304, 402) comprend une surface opposée (302) face à la cavité (310, 404), face à la zone réfléchissante (212, 306, 352, 406) et non face à la fenêtre de sortie de lumière (312, 408), et dans lequel la seconde source de lumière (210) est agencée sur la surface opposée (302).

10. Ensemble électroluminescent (200, 502) selon la revendication 9, dans lequel
- le boîtier (304, 402) comprend un élément protubérant (308) dépassant dans la cavité (310, 404), dans lequel une surface de l'élément protubérant (308) est la surface opposée (302).

11. Ensemble électroluminescent (200, 502) selon la revendication 9, dans lequel
- le boîtier (304, 402) comprend au moins une paroi plate,
- la paroi plate comprend la fenêtre de sortie de lumière (312, 408) et la paroi plate comprend au moins au niveau d'un bord de la fenêtre de sortie de lumière (312, 408), une partie de paroi opaque (412) qui comprend la surface opposée (302).

12. Ensemble électroluminescent (200, 502) selon la revendication 8, dans lequel la zone réfléchissante (212, 306, 352, 406) est au moins une partie d'une surface du boîtier (304, 402) qui est face à la cavité (310, 404).

13. Lampe (300, 350, 400, 500) comprenant l'ensemble électroluminescent (200, 502) selon l'une quelconque des revendications 1 à 12.

14. Luminaire (600) comprenant l'ensemble électroluminescent selon l'une quelconque des revendications 1 à 12 ou comprenant la lampe (300, 350, 400, 500) selon la revendication 13.
